# EUROPEAN PATENT APPLICATION

(11) **EP 4 658 038 A1**
(43) Date of publication of application: **03.12.2025**
(21) Application number: 24791694.3
(22) Date of filing: 26.01.2024
(51) Int. Cl.: H10K 30/80

(54) **LIGHT CONVERSION LAYER, SOLAR CELL, AND ELECTRICAL DEVICE**

(30) Priority: 21.04.2023 CN 202310431080
(71) Applicant: Contemporary Amperex Technology Co., Limited, Ningde, Fujian 352100 (CN)
(72) Inventor: CHEN, Changsong, Ningde, Fujian 352100 (CN); SU, Shuojian, Ningde, Fujian 352100 (CN); LIN, Xiangling, Ningde, Fujian 352100 (CN); LI, Hanfang, Ningde, Fujian 352100 (CN); MENG, Ke, Ningde, Fujian 352100 (CN); CHEN, Junchao, Ningde, Fujian 352100 (CN); GUO, Yongsheng, Ningde, Fujian 352100 (CN)
(74) Representative: Kraus & Lederer PartGmbB
(86) International application number: PCT/CN2024/074286
(87) International publication number: WO 2024/217106

(57) **Abstract**

The present application relates to the technical field of solar cells, and in particular to a light conversion layer, a solar cell, and an electrical apparatus. The light conversion layer includes a conversion material. The conversion material includes an up-conversion luminescent material and/or a down-conversion luminescent material. The light conversion layer is arranged on a light incident side of a light absorption layer of the solar cell. By introducing the light conversion layer including the up-conversion luminescent material and/or the down-conversion luminescent material into the solar cell, long-wavelength band (low energy) and/or short-wavelength band (high energy) photons can be absorbed and converted into wavebands that can be absorbed by the light absorption layer, which is beneficial to improving the solar spectrum utilization rate and the output performance of the solar cell.

## Description

### CROSS-REFERENCE TO RELATED APPLICATIONS

The present application claims priority to Chinese Patent Application No. 202310431080.5, filed on April 21, 2023, the content of which is incorporated into the present application by reference in its entirety.

### TECHNICAL FIELD

The present application relates to the technical field of solar cells, and in particular to a light conversion layer, a solar cell, and an electrical apparatus.

### BACKGROUND

Solar cells are devices that directly convert light energy into electric energy by photoelectric effect or photochemical effect.

However, the solar spectrum utilization rate of solar cells in traditional photovoltaic devices is limited.

### SUMMARY OF THE INVENTION

A main object of the present application is to provide a light conversion layer, aiming at improving the solar spectrum utilization rate of a solar cell and improving the performance of the solar cell.

In order to achieve the above object, the present application provides a light conversion layer. The light conversion layer comprises a conversion material. The conversion material includes an up-conversion luminescent material and/or a down-conversion luminescent material. The light conversion layer is arranged on a light incident side of a light absorption layer of the solar cell.

By introducing the light conversion layer, which is arranged on a light incident side of the light absorption layer of the solar cell and comprises the up-conversion luminescent material and/or the down-conversion luminescent material, into the solar cell, long-wavelength band (low energy) and/or short-wavelength band (high energy) photons can be absorbed and converted into wavebands that can be absorbed by the light absorption layer, which is beneficial to improving the solar spectrum utilization rate and the output performance of the solar cell.
Optionally, the solar cell comprises an upper electrode, and the light conversion layer is arranged on a surface of the upper electrode;
and/or the solar cell comprises an upper electrode and a first charge transport layer, and the light conversion layer is arranged between the upper electrode and the first charge transport layer;
and/or the solar cell comprises a first charge transport layer and a light absorption layer, and the light conversion layer is arranged between the first charge transport layer and the light absorption layer.

It can be understood that the light conversion layer can be arranged on a surface of the upper electrode. The light conversion layer can be arranged between the upper electrode and the first charge transport layer. The light conversion layer can be arranged between the first charge transport layer and the light absorption layer.

Optionally, the solar cell comprises an upper electrode, the light conversion layer is the upper electrode, and the light conversion layer comprises an upper electrode material and the conversion material.

It can be understood that the light conversion layer can be independently a single-layer structure, or may also be composited with other layer structures in the solar cell. For example, the light conversion layer is composited with the upper electrode, so that the upper electrode has the function of the light conversion layer, that is, the light conversion layer is the upper electrode, and the light conversion layer comprises an upper electrode material and a conversion material.

Optionally, the solar cell comprises a first charge transport layer, the light conversion layer is the first charge transport layer, and the light conversion layer comprises a charge transport material and the conversion material.

The light conversion layer is composited with the first charge transport layer. The light conversion layer is a first charge transport layer, and the light conversion layer comprises a charge transport material and a conversion material.

The up-conversion luminescent material and/or the down-conversion luminescent material are combined with the charge transport layer material, so that the solar spectrum utilization rate can be improved without affecting the intrinsic structural performance of the cell, thus significantly improving the device performance.

That is, compared with the separate arrangement of the up-conversion layer and/or down-conversion layer and the charge transport layer, on the one hand, the provision of the multilayer structure results in increased complexity of the process and requires additional film-making working procedures; on the other hand, the heterogeneous interface is enhanced and the resistance on the carrier transmission path is increased, including the influence of parasitic resistance and interface defects, thereby reducing the photoelectric conversion performance of the device. The light conversion layer proposed by the present application (the up-conversion luminescent material and/or down-conversion luminescent material are combined with the charge transport layer material) can avoid the above two problems and improve the solar spectrum utilization rate without changing the original physical structure of the cell.

Optionally, the proportion of the mass of the conversion material in the total mass of the materials of the light conversion layer is in a range of 1% to 75%.

The conversion material includes an up-conversion luminescent material and/or a down-conversion luminescent material. By mixing the conversion material with the charge transport material, a light conversion layer having a charge transport function and a light conversion function is obtained, which can improve the solar spectrum utilization rate of the solar cell.

It can be understood that the light conversion layer not only improves the solar spectrum utilization rate by means of the conversion material therein, but also realizes the charge transport function by means of the charge transport material. That is, the amounts of the charge transport material and the conversion material should be both considered. It is necessary to avoid using an excessively low amount of the charge transport material in the light conversion layer in order to prevent a reduction in photoelectric conversion efficiency. It can be understood that the photoelectric conversion efficiency is the ratio of the total power output of a cell device under light to the incident light power. If the amount of the charge transport material in the photoelectric conversion layer is too low, the ability to transfer electrons or holes through the light conversion layer will decrease, and the photoelectric conversion efficiency will decrease. It is also necessary to avoid using an excessively low amount of the conversion material in the light conversion layer to avoid that the solar spectrum utilization rate is not appreciably improved. In order to balance the solar spectrum utilization rate and the photoelectric conversion efficiency, the proportion of the mass of the conversion material in the total mass of the materials of the light conversion layer is in a range of 1% to 75%.

Optionally, the proportion of the mass of the conversion material in the total mass of the materials of the light conversion layer is in a range of 25% to 60%.

In order to balance the solar spectrum utilization rate and the photoelectric conversion efficiency, the proportion of the mass of the conversion material in the total mass of the materials of the light conversion layer is in a range of 25% to 60%.

Optionally, the thickness of the light conversion layer is in a range of 30 nm to 60 nm.

In the case of the same material, the thickness of the light conversion layer affects the energy conversion efficiency of the solar cell. In order for the solar cell to have an appropriate energy conversion efficiency, the thickness of the light conversion layer is in a range of 30 nm to 60 nm.

Optionally, the thickness of the light conversion layer is in a range of 40 nm to 50 nm.

In the case of the same material, the thickness of the light conversion layer affects the energy conversion efficiency of the solar cell. In order for the solar cell to have an appropriate energy conversion efficiency, the thickness of the light conversion layer is in a range of 40 nm to 50 nm.

Optionally, the light conversion layer comprises the charge transport material, the up-conversion luminescent material, and the down-conversion luminescent material, and the proportion of the mass of the up-conversion luminescent material in the total mass of the materials of the light conversion layer is greater than 0 and less than or equal to 25%;
the proportion of the mass of the down-conversion luminescent material in the total mass of the materials of the light conversion layer is greater than 0 and less than or equal to 25%; and
the proportion of the mass of the charge transport material in the total mass of the materials of the light conversion layer is greater than or equal to 50% and less than 100%.

The conversion material includes an up-conversion luminescent material and a down-conversion luminescent material. By mixing the conversion material with the charge transport material, a light conversion layer having a charge transport function and a light conversion function is obtained, and the light conversion layer can improve the solar spectrum utilization rate of the solar cell. In order to balance the solar spectrum utilization rate and the photoelectric conversion efficiency, the proportion of the mass of the up-conversion luminescent material in the total mass of the materials of the light conversion layer is greater than 0 and less than or equal to 25%; the proportion of the mass of the down-conversion luminescent material in the total mass of the materials of the light conversion layer is greater than 0 and less than or equal to 25%; and the proportion of the mass of the charge transport material in the total mass of the materials of the light conversion layer is greater than or equal to 50% and less than 100%.

Optionally, the conversion material includes an up-conversion luminescent material, and the up-conversion luminescent material includes at least one of an organic compound or an inorganic compound.

In the present application, the type of the up-conversion luminescent material is not limited, as long as the up-conversion luminescent material can improve the solar spectrum utilization rate, for example, it can be an organic compound and/or an inorganic compound.

Optionally, the organic compound includes at least one of 4CzIPN, thioxanthone, and triphenylamine;
and/or the inorganic compound includes at least one of NaYF₄, NaLuF₄, NaGdF₄, NaYbF₄, NaYGd, NaYLu, NaYNd, NaGd(WO₄)₂, LiErF, BaYF₅, BaLuF₅, BaGdF₅, BaYb₂F, CaS, LiLa(MoO₄)₂, Gd₂O₃, ZrYO, YAlO₃, CaWO₄, and the NaYF₄, NaLuF₄, NaGdF₄, NaYbF₄, NaYGd, NaYLu, NaYNd, NaGd(WO₄)₂, LiErF, BaYF₅, BaLuF₅, BaGdF₅, BaYb₂F, CaS, LiLa(MoO₄)₂, Gd₂O₃, ZrYO, YAlO₃, and CaWO₄ doped with one or more of the rare earth elements Yb, Er, Tm, Eu, Sm, Bi, and Ho.

In the present application, the type of the up-conversion luminescent material is not limited, as long as the up-conversion luminescent material can improve the solar spectrum utilization rate, for example, the up-conversion luminescent material includes at least one of NaYF₄, NaLuF₄, NaGdF₄, NaYbF₄, NaYGd, NaYLu, NaYNd, NaGd(WO₄)₂, LiErF, BaYF₅, BaLuF₅, BaGdF₅, BaYb₂F, CaS, LiLa(MoO₄)₂, Gd₂O₃, ZrYO, YAlO₃, CaWO₄, 4CzIPN, and rare earth element-doped NaYF₄, NaLuF₄, NaGdF₄, NaYbF₄, NaYGd, NaYLu, NaYNd, NaGd(WO₄)₂, LiErF, BaYF₅, BaLuF₅, BaGdF₅, BaYb₂F, CaS, LiLa(MoO₄)₂, Gd₂O₃, ZrYO, YAlO₃, CaWO₄, 4CzIPN, thioxanthone and derivatives thereof, and triphenylamine and derivatives thereof. The above listed up-conversion luminescent materials are only examples, and the up-conversion luminescent material in the present application may also include materials other than the above materials.

Optionally, the conversion material includes a down-conversion luminescent material, and the down-conversion luminescent material includes a fluorescent material and/or a phosphorescent material.

Optionally, the down-conversion luminescent material includes a fluorescent material, and the fluorescent material includes at least one of riboflavin, a fluorescein compound, a rhodamine compound, phycoerythrin, an iridium complex, a rare earth element complex, a polyfluorene compound, a coumarin compound, a naphthalimide compound, a polyacene compound, a fluorine-and-boron-based dipyrrole compound, a Resorufin compound, a pyrazoline compound, a triphenylamine compound, a carbazole compound, a green fluorescent protein, a diamine fluorescent compound, a perovskite luminescent nanomaterial, and a thermally activated delayed fluorescent compound;
and/or the down-conversion luminescent material includes a phosphorescent material, the phosphorescent material comprises a matrix, and the matrix includes at least one of sulfide, oxide, selenide, fluoride, phosphate, silicate, and tungstate of a metal of group II;
and/or the down-conversion luminescent material includes a phosphorescent material, the phosphorescent material comprises a matrix and an activator, and the activator comprises a heavy metal.

In the present application, the type of the down-conversion luminescent material is not limited, for example, as long as it can absorb short-wavelength band (high energy) photons and convert the photons into visible light bands that can be effectively absorbed by the light absorption layer. The above listed down-conversion luminescent material are only examples, and the down-conversion luminescent material in the present application may also include materials other than the above materials.

Optionally, the charge transport material includes an electron transport material or a hole transport material.

Optionally, the electron transport material includes at least one of an imide compound, a quinone compound, fullerene and a derivative thereof, a metal oxide, a semiconductor material oxide, a titanate, and a fluoride.

Optionally, the imide compound includes at least one of phthalimide, succinimide, N-bromosuccinimide, glutarimide, or maleimide;
and/or the quinone compound includes at least one of benzoquinone, naphthoquinone, phenanthrenequinone, or anthraquinone;
and/or the fullerene and the derivative thereof includes at least one of C₆₀ and PCBM;
and/or the metal element in the metal oxide includes at least one of Mg, Cd, Zn, In, Pb, W, Sb, Bi, Hg, Ti, Ag, Mn, Fe, V, Sn, Zr, Sr, Ga, and Cr;
and/or the semiconductor material oxide includes silicon oxide;
and/or the titanate includes at least one of strontium titanate and calcium titanate;
and/or the fluoride includes at least one of lithium fluoride and calcium fluoride.

The electron transport material has the function of transporting electrons to the corresponding electrodes and preventing the electrons from diffusing in the opposite direction. In the present application, the electron transport material is not limited, and may be either any one or more of the above listed materials or a material other than those in the present application.

For example, the electron transport material includes but is not limited to at least one of an imide compound, a quinone compound, fullerene and a derivative thereof, a metal oxide, silicon oxide, strontium titanate, calcium titanate, lithium fluoride, and calcium fluoride, and the metal element in the metal oxide includes at least one of Mg, Cd, Zn, In, Pb, W, Sb, Bi, Hg, Ti, Ag, Mn, Fe, V, Sn, Zr, Sr, Ga, and Cr.

Optionally, the hole transport material includes at least one of 2,2',7,7'-tetrakis(N,N-p-methoxyaniline)-9,9'-spirobifluorene, methoxytriphenylamine-fluoroformamidine, poly[bis(4-phenyl)(2,4,6-trimethylphenyl)amine], poly(3,4-ethylenedioxythiophene), polystyrene sulfonic acid, poly(3-hexylthiophene), triphenylamine with triptycene as a core, 3,4-ethylenedioxythiophene-methoxytriphenylamine, N-(4-aniline)carbazole-spirobifluorene, polythiophene, phosphoryl single molecule, carbazolyl single molecule, sulfo single molecule, triphenylamine single molecule, aryl single molecule, metal oxide, and cuprous thiocyanate, and the metal element in the metal oxide includes at least one of Ni, Mo, and Cu.

The hole transport material has the function of transporting holes to the corresponding electrodes and preventing the holes from diffusing in the opposite direction. In the present application, the hole transport material is not limited, and hole transport material may be either any one or more of the above listed materials, or a material other than that in the present application.

For example, the hole transport material includes, but is not limited to, 2,2',7,7'-tetrakis(N,N-p-methoxyaniline)-9,9'-spirobifluorene, methoxytriphenylamine-fluoroformamidine, poly[bis(4-phenyl)(2,4,6-trimethylphenyl)amine], poly(3,4-ethylenedioxythiophene), polystyrene sulfonic acid, poly(3-hexylthiophene), triphenylamine with triptycene as a core, 3,4-ethylenedioxythiophene-methoxytriphenylamine, N-(4-aniline)carbazole-spirobifluorene, polythiophene, phosphoryl single molecule, carbazolyl single molecule, sulfo single molecule, triphenylamine single molecule, aryl single molecule, metal oxide, and cuprous thiocyanate, and the metal element in the metal oxide includes at least one of Ni, Mo, and Cu.

The present application further provides a solar cell. The solar cell comprises the light conversion layer.

Optionally, in a first direction, the solar cell comprises sequentially an upper electrode, a first charge transport layer, a light absorption layer, a second charge transport layer, and a lower electrode;
the first charge transport layer comprises the light conversion layer, and the charge transport material in the first charge transport layer includes one of an electron transport material and a hole transport material; and
the charge transport material in the second charge transport layer includes the other one of the electron transport material and the hole transport material.

By introducing the up-conversion luminescent material and/or down-conversion luminescent material into the first charge transport layer, long-wavelength band (low energy) and/or short-wavelength band (high energy) photons can be absorbed and converted into wavebands that can be absorbed by the light absorption layer, which is beneficial to improving the solar spectrum utilization rate and the output performance of the solar cell.

Optionally, the materials of the upper electrode and/or the lower electrode include an organic conductive material and/or an inorganic conductive material.

Optionally, the organic conductive material includes at least one of poly(3,4-ethylenedioxythiophene), polythiophene, and polyacetylene;
and/or the inorganic conductive material includes at least one of fluorine-doped SnO₂ transparent conductive glass, aluminum-doped zinc oxide transparent conductive glass, and a metal.

In the present application, the specific types of the materials of the upper electrode and the lower electrode are not limited, as long as it can achieve the conductive function. It can be an organic conductive material, e.g., a conductive polymer (poly(3,4-ethylenedioxythiophene), polythiophene, polyacetylene, etc.); or may be an inorganic conductive material, e.g., a transparent conductive oxide (FTO, ITO, AZO, etc.), a metal, or a carbon derivative.

Optionally, the material of the light absorption layer includes perovskite, and the structural formula of the perovskite is ABX₃, where A is an inorganic cation and/or an organic cation, B is an inorganic cation and/or an organic cation, and X is an inorganic anion and/or an organic anion.

In the present application, the material of the light absorption layer is not limited. Preferably, the material of the light absorption layer includes perovskite, and the structural formula of the perovskite is ABX₃, where A is an inorganic cation and/or an organic cation, B is an inorganic cation and/or an organic cation, and X is an inorganic anion and/or an organic anion.

Perovskite materials are usually a large class of materials with an ABX₃ structure as the main structure. For example, the A position is Cs⁺, CH₃NH₂⁺, and CH₂(NH₂)⁺, the B position is Pb²⁺ or Sn²⁺, and X is a halogen ion of Cl⁻, Br⁻, I⁻, etc. It is a cubic close-packed structure formed by the halide octahedron BX₆ and the cation in the A position under the action of hydrogen bonding. An organic-inorganic hybrid lead halide perovskite with this structure has the advantages of a low cost, a high visible light internal absorption coefficient, a high carrier mobility, an adjustable band gap, easy synthesis by a solution method, etc.

The present application further provides an electrical apparatus. The electrical apparatus comprises the solar cell.

The light conversion layer in the present application comprises a conversion material. The conversion material includes an up-conversion luminescent material and/or a down-conversion luminescent material. By introducing the up-conversion luminescent material and/or down-conversion luminescent material into the light conversion layer, long-wavelength band (low energy) and/or short-wavelength band (high energy) photons can be absorbed and converted into wavebands that can be absorbed by the light absorption layer, which is beneficial to improving the solar spectrum utilization rate and the output performance of the solar cell.

### DESCRIPTION OF DRAWINGS

To describe the technical solutions in the embodiments of the present application or the prior art more clearly, the accompanying drawings required for describing the embodiments or the prior art will be briefly introduced below. Apparently, the accompanying drawings described in the following are merely some of the embodiments of the present application, and those of ordinary skill in the art may also derive other drawings from structures shown by these accompanying drawings without creative efforts.

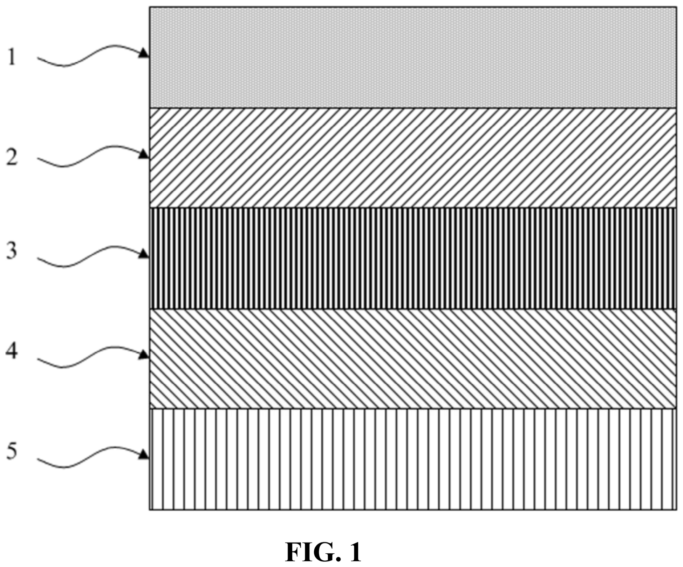

FIG. 1 is a schematic structural view of a solar cell according to one embodiment of the present application.

### Description of reference numerals:

| Reference numeral | Name | Reference numeral | Name |
|---|---|---|---|
| 1 | Upper electrode | 4 | Second charge transport layer |
| 2 | First charge transport layer | 5 | Lower electrode |
| 3 | Light absorption layer | | |

The implementation of the object, functional features, and advantages of the present application will be further described in conjunction with embodiments and with reference to the accompanying drawings.

### DETAILED DESCRIPTION

The technical solutions in the embodiments of the present application will be clearly and completely described below with reference to the accompanying drawings of the embodiments of the present application. Apparently, the embodiments described are merely some rather than all of the embodiments of the present application. Based on the embodiments in the present application, all other embodiments obtained by those of ordinary skill in the art without creative effort fall within the scope of protection of the present application.

Embodiments of a solar cell of the present application are specifically disclosed below with reference to detailed description of the accompanying drawings. However, there may be cases where unnecessary detailed descriptions are omitted. For example, there are cases where detailed descriptions of well-known items and repeated descriptions of actually identical structures are omitted. This is to avoid unnecessary redundancy in the following descriptions and to facilitate understanding by those skilled in the art. In addition, the drawings and subsequent descriptions are provided for those skilled in the art to fully understand the present application, and are not intended to limit the subject matter recited in the claims.

"Ranges" disclosed in the present application are defined in the form of lower limits and upper limits, a given range is defined by the selection of a lower limit and an upper limit, and the selected lower limit and upper limit define boundaries of a particular range. A range defined in this manner may be inclusive or exclusive of end values, and may be arbitrarily combined, that is, any lower limit may be combined with any upper limit to form a range. For example, if the ranges 60-120 and 80-110 are listed for specific parameters, it is understood that the ranges 60-110 and 80-120 are also expected. Additionally, if the minimum range values 1 and 2 are listed, and if the maximum range values 3, 4 and 5 are listed, the following ranges are all contemplated: 1-3, 1-4, 1-5, 2- 3, 2-4 and 2-5. In the present application, unless stated otherwise, the numerical range "a-b" represents an abbreviated representation of any combination of real numbers between a to b, where both a and b are real numbers. For example, the numerical range "0-5" indicates that all real numbers between "0-5" have been listed herein, and "0-5" is only a shortened representation of these numerical combinations. In addition, when a parameter is expressed as an integer greater than or equal to 2, it is equivalent to disclosing that the parameter is, for example, an integer of 2, 3, 4, 5, 6, 7, 8, 9, 10, 11, 12, etc.

Unless otherwise specified, all embodiments and optional embodiments of the present application may be combined with each other to form new technical solutions.

Unless otherwise specified, all technical features and optional technical features of the present application may be combined with each other to form new technical solutions.

Unless otherwise specified, all steps of the present application may be performed sequentially or randomly, and preferably sequentially. For example, the method comprises steps (a) and (b), meaning that the method may comprise steps (a) and (b) performed sequentially, or may comprise steps (b) and (a) performed sequentially. For example, reference to "the method may further include step (c)" indicates that step (c) may be added to the method in any order, for example, the method may include steps (a), (b), and (c), or steps (a), (c), and (b), or steps (c), (a), and (b), etc.

Solar cells in traditional photovoltaic devices have limited solar spectrum utilization rates.

For example, the optical band gap of light absorption layer materials (such as perovskite) in traditional photovoltaic devices is fixed. The optical band gap is the energy barrier of electron transition in the substance when light interacts with the substance, which is determined by the energy band structure of the substance itself and is the energy that electrons need to absorb photons when the electrons cross this band gap to reach the excited state. Since the absorption spectrum of the light absorption layer material is fixed, the long-wavelength band will directly penetrate the light absorption layer, and the solar spectrum cannot be utilized to the maximum extent; and the short-wavelength band will be absorbed by the light absorption layer but may cause great damage to the material. For example, due to the relatively high optical energy and activation, ultraviolet light can directly catalyze a redox reaction of MA⁺ and I⁻ in MAPbI₃ (MA=CH₃NH₃⁺) perovskite to generate elemental iodine and methylamine gas, resulting in lattice damage and thin film aging.

In order to improve the solar spectrum utilization rate of the solar cell, the present application provides a light conversion layer. The light conversion layer comprises a conversion material. The conversion material includes an up-conversion luminescent material and/or a down-conversion luminescent material. The light conversion layer is arranged on a light incident side of a light absorption layer of the solar cell.

Up-conversion luminescence: The luminescence process of up-conversion luminescence refers to a luminescence process of emitting high-energy light (short wavelength) by various conversion methods under excitation by low-energy light (long wavelength).

Up-conversion luminescent material: The material is excited by low-energy light to emit high-energy light, that is, when excited by light with a long wavelength and a low frequency, the material emits light with a short wavelength and a high frequency.

Down-conversion luminescence: High-energy (short wavelength) light emits light with low energy (long wavelength) after excitation. This luminescence mode is also referred to as down-conversion luminescence.

Down-conversion luminescent material: The optically active substance emits low-energy photons under excitation by high-energy photons. The material refers to a material that can emit one or more low-energy photons after absorbing one high-energy photon of ultraviolet light.

Light absorption layer: The light absorption layer comprises a light absorption material and a material with a photoelectric conversion function. The light absorption material absorbs photons of sunlight to generate excitation and excite electrons in a valence band to generate photoinduced hole and electron pairs.

The light conversion layer is arranged on the light incident side of the light absorption layer of the solar cell, which means that the light conversion layer is arranged on the side where light enters the light absorption layer.

By introducing the light conversion layer comprising the up-conversion luminescent material and/or the down-conversion luminescent material into the solar cell, long-wavelength band (low energy) and/or short-wavelength band (high energy) photons can be absorbed and converted into wavebands that can be absorbed by the light absorption layer, which is beneficial to improving the solar spectrum utilization rate and the output performance of the solar cell.

In one embodiment, the solar cell comprises an upper electrode, and the light conversion layer is arranged on a surface of the upper electrode; and/or, the solar cell comprises an upper electrode and a first charge transport layer, and the light conversion layer is arranged between the upper electrode and the first charge transport layer; and/or the solar cell comprises a first charge transport layer and a light absorption layer, and the light conversion layer is arranged between the first charge transport layer and the light absorption layer.

FIG. 1 shows a schematic structural view of a solar cell according to one embodiment. The solar cell comprises, sequentially from top to bottom, an upper electrode 1, a first charge transport layer 2, a light absorption layer 3, a second charge transport layer 4, and a lower electrode 5.

Electrode: The main function of the electrode is to collect electrons/holes from the charge transport layer.

Light absorption layer: The light absorption layer comprises a light absorption material and a material with a photoelectric conversion function. The light absorption material absorbs photons of sunlight to generate excitation and excite electrons in a valence band to generate photoinduced hole and electron pairs.

Charge transport layer: FIG. 1 shows a schematic structural view of a solar cell. The charge transport layer 2 is located between the electrode and the light absorption layer as a layered structure for transporting electrons or holes. The charge transport layer is composed of a material for transporting electrons or holes and is used for transporting electrons to the corresponding electrode and preventing electrons or holes from diffusing in the opposite direction.

It can be understood that the light conversion layer can be arranged on a surface of the upper electrode. The light conversion layer can be arranged between the upper electrode and the first charge transport layer. The light conversion layer can be arranged between the first charge transport layer and the light absorption layer.

In one embodiment, the solar cell comprises an upper electrode, the light conversion layer is the upper electrode, and the light conversion layer comprises an upper electrode material and the conversion material.

It can be understood that the light conversion layer can be independently a single-layer structure, or may also be composited with other layer structures in the solar cell. For example, the light conversion layer is composited with the upper electrode, so that the upper electrode has the function of the light conversion layer, that is, the light conversion layer is the upper electrode, and the light conversion layer comprises an upper electrode material and a conversion material.

In one embodiment, the solar cell comprises a first charge transport layer, the light conversion layer is the first charge transport layer, and the light conversion layer comprises a charge transport material and the conversion material.

The light conversion layer is composited with the first charge transport layer. The light conversion layer is a first charge transport layer, and the light conversion layer comprises a charge transport material and a conversion material.

By introducing the up-conversion luminescent material and/or down-conversion luminescent material into the first charge transport layer, long-wavelength band (low energy) and/or short-wavelength band (high energy) photons can be absorbed and converted into wavebands that can be absorbed by the light absorption layer, which is beneficial to improving the solar spectrum utilization rate and the output performance of the solar cell.

In addition, the up-conversion luminescent material and/or the down-conversion luminescent material are combined with the charge transport layer material, so that the solar spectrum utilization rate can be improved without affecting the intrinsic structural performance of the cell, thus significantly improving the device performance.

That is, compared with the separate arrangement of the up-conversion layer and/or down-conversion layer and the charge transport layer, on the one hand, the provision of the multilayer structure results in increased complexity of the process and requires additional film-making working procedures; on the other hand, the heterogeneous interface is enhanced and the resistance on the carrier transmission path is increased, including the influence of parasitic resistance and interface defects, thereby reducing the photoelectric conversion performance of the device. The light conversion layer proposed by the present application (the up-conversion luminescent material and/or down-conversion luminescent material are combined with the charge transport layer material) can avoid the above two problems and improve the solar spectrum utilization rate without changing the original physical structure of the cell.

Photovoltaic principle of perovskite solar cell: Sunlight enters the device from the transparent conductive glass, passes through the electron transport layer, reaches the perovskite active layer, and is absorbed thereby to excite electrons in the valence band to generate photoinduced hole and electron pairs. Under the action of the built-in electric field, holes and electrons undergo charge separation, and the photoinduced electrons migrate to the electron transport layer and are then collected by the electrode; at the same time, the holes in the perovskite layer are transported to the hole transport layer and then conducted to the electrode. The electrons and holes subsequently drive the load to work via an external circuit.

In one embodiment, the proportion of the mass of the conversion material in the total mass of the materials of the light conversion layer is in a range of 1% to 75%.

The conversion material includes an up-conversion luminescent material and/or a down-conversion luminescent material. By mixing the conversion material with the charge transport material, a light conversion layer having a charge transport function and a light conversion function is obtained, which can improve the solar spectrum utilization rate of the solar cell.

It can be understood that the light conversion layer not only improves the solar spectrum utilization rate by means of the conversion material therein, but also realizes the charge transport function by means of the charge transport material. That is, the amounts of the charge transport material and the conversion material should be both considered. It is necessary to avoid using an excessively low amount of the charge transport material in the light conversion layer in order to prevent a reduction in photoelectric conversion efficiency. It can be understood that the photoelectric conversion efficiency is the ratio of the total power output of a cell device under light to the incident light power. If the amount of the charge transport material in the photoelectric conversion layer is too low, the ability to transfer electrons or holes through the light conversion layer will decrease, and the photoelectric conversion efficiency will decrease. It is also necessary to avoid using an excessively low amount of the conversion material in the light conversion layer to avoid that the solar spectrum utilization rate is not appreciably improved. In order to balance the solar spectrum utilization rate and the photoelectric conversion efficiency, the proportion of the mass of the conversion material in the total mass of the materials of the light conversion layer is in a range of 1% to 75%.

From the above 1% to 75%, the values include the minimum and maximum values of the range and every value between the minimum and maximum values. Specific examples include but are not limited to point values in the embodiments and 1%, 10%, 15%, 20%, 25%, 30%, 35%, 40%, 45%, 50%, 55%, 60%, 65%, 70%, 75%, etc., as well as values in a range between any two of the above point values.

In one embodiment, the proportion of the mass of the conversion material in the total mass of the material of the charge transport layer is in a range of 25% to 60%.

The conversion material includes an up-conversion luminescent material and/or a down-conversion luminescent material. By introducing the conversion material into the light conversion layer, the solar spectrum utilization rate of the solar cell can be improved.

It can be understood that the light conversion layer may be an up-conversion luminescent material mixed with a charge transport layer material, or may also be a down-conversion luminescent material mixed with a charge transport layer material, or may still be an up-conversion luminescent material and a down-conversion luminescent material mixed with a charge transport layer material.

In order to balance the solar spectrum utilization rate and the photoelectric conversion efficiency, the proportion of the mass of the conversion material in the total mass of the materials of the light conversion layer is in a range of 25% to 60%.

From the above 25% to 60%, the values include the minimum and maximum values of the range and every value between the minimum and maximum values. Specific examples include but are not limited to point values in the embodiments and 25%, 26%, 28%, 30%, 35%, 40%, 45%, 50%, 55%, 60%, etc., as well as values in a range between any two of the above point values.

In one embodiment, the thickness of the charge transport layer is in a range of 30 nm to 60 nm.

In the case of the same material, the thickness of the light conversion layer affects the energy conversion efficiency of the solar cell. In order for the solar cell to have an appropriate energy conversion efficiency, the thickness of the light conversion layer is in a range of 30 nm to 60 nm.

From the above 30 nm to 60 nm, the values include the minimum and maximum values of the range and every value between the minimum and maximum values. Specific examples include but are not limited to point values in the embodiments and 30 nm, 35 nm, 40 nm, 45 nm, 50 nm, 55 nm, 60 nm, etc., as well as values in a range between any two of the above point values.

In one embodiment, the thickness of the light conversion layer is in a range of 40 nm to 50 nm.

In order for the solar cell to have an appropriate energy conversion efficiency, the thickness of the light conversion layer is in a range of 40 nm to 50 nm.

From the above 40 nm to 50 nm, the values include the minimum and maximum values of the range and every value between the minimum and maximum values. Specific examples include but are not limited to point values in the embodiments and 40 nm, 42 nm, 44 nm, 45 nm, 47 nm, 49 nm, 50 nm, etc., as well as values in a range between any two of the above point values.

In one embodiment, the light conversion layer comprises a charge transport material, an up-conversion luminescent material, and a down-conversion luminescent material, and the proportion of the mass of the up-conversion luminescent material in the total mass of the materials of the light conversion layer is greater than 0 and less than or equal to 25%; the proportion of the mass of the down-conversion luminescent material in the total mass of the materials of the light conversion layer is greater than 0 or less than or equal to 25%; and the proportion of the mass of the charge transport material in the total mass of the materials of the light conversion layer is greater than or equal to 50% and less than 100%.

The conversion material includes an up-conversion luminescent material and a down-conversion luminescent material. By mixing the conversion material with the charge transport material, a light conversion layer having a charge transport function and a light conversion function is obtained, and the light conversion layer can improve the solar spectrum utilization rate of the solar cell. In order to balance the solar spectrum utilization rate and the photoelectric conversion efficiency, the proportion of the mass of the up-conversion luminescent material in the total mass of the materials of the light conversion layer is greater than 0 and less than or equal to 25%; the proportion of the mass of the down-conversion luminescent material in the total mass of the materials of the light conversion layer is greater than 0 and less than or equal to 25%; and the proportion of the mass of the charge transport material in the total mass of the materials of the light conversion layer is greater than or equal to 50% and less than 100%.

The proportion of the mass of the up-conversion luminescent material in the total mass of the materials of the light conversion layer is greater than 0 and less than or equal to 25%, including 0.5%, 1%, 5%, 10%, 15%, 20%, 25%, etc., as well as values in a range between any two of the above point values.

The proportion of the mass of the down-conversion luminescent material in the total mass of the materials of the light conversion layer is greater than 0 and less than or equal to 25%, including 0.5%, 5%, 10%, 15%, 20%, 25%, etc., as well as values in a range between any two of the above point values.

The proportion of the mass of the charge transport material in the total mass of the materials of the light conversion layer is greater than or equal to 50% and less than 100%, including 50%, 55%, 60%, 65%, 70%, 75%, 80%, 85%, 90%, 95%, 99%, etc., as well as values in a range between any two of the above point values.

In one embodiment, the conversion material includes an up-conversion luminescent material, and the up-conversion luminescent material includes at least one of an organic compound or an inorganic compound.

In the present application, the type of the up-conversion luminescent material is not limited, as long as the up-conversion luminescent material can improve the solar spectrum utilization rate, for example, it can be an organic compound and/or an inorganic compound.

In one embodiment, the organic compound includes at least one of 4CzIPN, thioxanthone, and triphenylamine; and/or the inorganic compound includes at least one of NaYF₄, NaLuF₄, NaGdF₄, NaYbF₄, NaYGd, NaYLu, NaYNd, NaGd(WO₄)₂, LiErF, BaYF₅, BaLuF₅, BaGdF₅, BaYb₂F, CaS, LiLa(MoO₄)₂, Gd₂O₃, ZrYO, YAlO₃, and CaWO₄, and the NaYF₄, NaLuF₄, NaGdF₄, NaYbF₄, NaYGd, NaYLu, NaYNd, NaGd(WO₄)₂, LiErF, BaYF₅, BaLuF₅, BaGdF₅, BaYb₂F, CaS, LiLa(MoO₄)₂, Gd₂O₃, ZrYO, YAlO₃, and CaWO₄ doped with one or more of the rare earth elements Yb, Er, Tm, Eu, Sm, Bi, and Ho.

In the present application, the type of the up-conversion luminescent material is not limited, as long as the up-conversion luminescent material can improve the solar spectrum utilization rate, for example, the up-conversion luminescent material includes at least one of NaYF₄, NaLuF₄, NaGdF₄, NaYbF₄, NaYGd, NaYLu, NaYNd, NaGd(WO₄)₂, LiErF, BaYF₅, BaLuF₅, BaGdF₅, BaYb₂F, CaS, LiLa(MoO₄)₂, Gd₂O₃, ZrYO, YAlO₃, CaWO₄, 4CzIPN, and rare earth element-doped NaYF₄, NaLuF₄, NaGdF₄, NaYbF₄, NaYGd, NaYLu, NaYNd, NaGd(WO₄)₂, LiErF, BaYF₅, BaLuF₅, BaGdF₅, BaYb₂F, CaS, LiLa(MoO₄)₂, Gd₂O₃, ZrYO, YAlO₃, CaWO₄, thioxanthone and derivatives thereof, and triphenylamine and derivatives thereof. The above listed up-conversion luminescent materials are only examples, and the up-conversion luminescent material in the present application may also include materials other than the above materials.

In one embodiment, the conversion material includes a down-conversion luminescent material, and the down-conversion luminescent material includes a fluorescent material and/or a phosphorescent material.

Fluorescent materials, under the irradiation of ultraviolet light, show various colors of visible light according to the types and contents of metals and activators in pigments.

Phosphorescent materials are materials that can emit phosphorescence under the excitation of electromagnetic radiation and ion rays. Phosphorescence is a slow-emitting phenomenon of photoluminescence. When a substance at room temperature is irradiated by incident light with a certain wavelength (usually ultraviolet rays or X-rays), the substance absorbs light energy and enters an excited state (usually with a different spin multiplicity from the ground state), and then slowly deactivates and emits emergent light with a wavelength longer than the incident light (with the wavelength usually in the visible light waveband).

In one embodiment, the down-conversion luminescent material includes a fluorescent material, and the fluorescent material includes at least one of riboflavin, a fluorescein compound, a rhodamine compound, phycoerythrin, an iridium complex, a rare earth element complex, a polyfluorene compound, a coumarin compound, a naphthalimide compound, a polyacene compound, a fluorine-and-boron-based dipyrrole compound, a Resorufin compound, a pyrazoline compound, a triphenylamine compound, a carbazole compound, a green fluorescent protein, a diamine fluorescent compound, a perovskite luminescent nanomaterial, and a thermally activated delayed fluorescent compound; and/or the down-conversion luminescent material includes a phosphorescent material, and the phosphorescent material comprises a matrix, the matrix including at least one of sulfide, oxide, selenide, fluoride, phosphate, silicate, and tungstate of a metal of group II; and/or the down-conversion luminescent material includes a phosphorescent material, the phosphorescent material comprises a matrix and an activator, and the activator comprises a heavy metal.

In the present application, the type of the down-conversion luminescent material is not limited, and the down-conversion luminescent material may be either a material mentioned in the present application or a material not mentioned in the present application, as long as it can absorb short-wavelength band (high energy) photons and convert the photons into visible light bands that can be effectively absorbed by the light absorption layer. For example, the down-conversion luminescent material includes a fluorescent material and/or a phosphorescent material. The fluorescent material includes at least one of riboflavin, a fluorescein compound (including fluorescein isothiocyanate), a rhodamine compound (including tetraethyl rhodamine and tetramethyl rhodamine isothiocyanate), phycoerythrin, an iridium complex, a rare earth element complex (including chelates of trivalent rare earth lanthanides), a polyfluorene compound, a coumarin compound, a naphthalimide compound, a polyacene compound (including anthracene and tetracene), a fluorine-and-boron-based dipyrrole compound, a Resorufin compound, a pyrazoline compound, a triphenylamine compound, a carbazole compound, a green fluorescent protein, a diamine fluorescent compound, a perovskite luminescent nanomaterial, and a thermally activated delayed fluorescent compound (including 2,3,5,6-tetrakis(9-carbazolyl)-terephthalonitrile (4CzTPN)).

The phosphorescent material comprises a matrix and an activator. The matrix includes at least one of sulfide, oxide, selenide, fluoride, phosphate, silicate, and tungstate of a metal of group II. The activator comprises a heavy metal. For example, the matrix includes ZnS, BaS, CaS, CaWO₃, Ca₃(PO₄)₂, Zn₂SiO₄, and Y₃SiO₃. Heavy metals used as activators include Au, Cu, Mn, Ag, Bi, Pb, rare earth metals, etc.

Thermally activated delayed fluorescence (TADF) compounds, in which excitons can completely emit fluorescence from the triplet state back to the singlet state under thermal disturbance, are referred to as TADF (thermally activated delayed fluorescence).

The main mechanism of luminescence thereof is that the energy difference between the singlet state and the triplet state of a TADF material is relatively small, and the small energy difference is beneficial for triplet excitons to reach the singlet state through an effective reverse intersystem crossing process to form singlet excitons and then generate radiation transition luminescence.

In one embodiment, the charge transport material includes an electron transport material or a hole transport material.

The electron transport material has the function of transporting electrons to the corresponding electrodes and preventing the electrons from diffusing in the opposite direction.

The hole transport material has the function of transporting holes to the corresponding electrodes and preventing the holes from diffusing in the opposite direction.

In one embodiment, the electron transport material includes at least one of an imide compound, a quinone compound, fullerene and a derivative thereof, a metal oxide, a semiconductor material oxide, a titanate, and a fluoride.

In one embodiment, the imide compound includes at least one of phthalimide, succinimide, N-bromosuccinimide, glutarimide, or maleimide; and/or the quinone compound includes at least one of benzoquinone, naphthoquinone, phenanthraquinone, or anthraquinone; and/or the fullerene and the derivative thereof include at least one of C₆₀ and PCBM (methyl [6,6]-phenyl-C61-butyrate); and/or the metal element in the metal oxide include at least one of Mg, Cd, Zn, In, Pb, W, Sb, Bi, Hg, Ti, Ag, Mn, Fe, V, Sn, Zr, Sr, Ga, and Cr; and/or the semiconductor material oxide includes silicon oxide; and/or the titanate includes at least one of strontium titanate and calcium titanate; and/or the fluoride includes at least one of lithium fluoride and calcium fluoride.

The electron transport material has the function of transporting electrons to the corresponding electrodes and preventing the electrons from diffusing in the opposite direction. In the present application, the electron transport material is not limited, and may be either any one or more of the above listed materials or a material other than those in the present application.

For example, the electron transport material includes but is not limited to at least one of an imide compound, a quinone compound, fullerene and a derivative thereof, a metal oxide, silicon oxide, strontium titanate, calcium titanate, lithium fluoride, and calcium fluoride, and the metal element in the metal oxide includes at least one of Mg, Cd, Zn, In, Pb, W, Sb, Bi, Hg, Ti, Ag, Mn, Fe, V, Sn, Zr, Sr, Ga, and Cr.

In one embodiment, the hole transport material includes 2,2',7,7'-tetrakis(N,N-p-methoxyaniline)-9,9'-spirobifluorene, methoxytriphenylamine-fluoroformamidine, poly[bis(4-phenyl)(2,4,6-trimethylphenyl)amine], poly(3,4-ethylenedioxythiophene), polystyrene sulfonic acid, poly(3-hexylthiophene), triphenylamine with triptycene as a core, 3,4-ethylenedioxythiophene-methoxytriphenylamine, N-(4-aniline)carbazole-spirobifluorene, polythiophene, phosphoryl single molecule, carbazolyl single molecule, sulfo single molecule, triphenylamine single molecule, aryl single molecule, metal oxide, and cuprous thiocyanate, and the metal element in the metal oxide includes at least one of Ni, Mo, and Cu.

The hole transport material has the function of transporting holes to the corresponding electrodes and preventing the holes from diffusing in the opposite direction. In the present application, the hole transport material is not limited, and hole transport material may be either any one or more of the above listed materials, or a material other than that in the present application.

For example, the hole transport material includes, but is not limited to, 2,2',7,7'-tetrakis(N,N-p-methoxyaniline)-9,9'-spirobifluorene, methoxytriphenylamine-fluoroformamidine, poly[bis(4-phenyl)(2,4,6-trimethylphenyl)amine], poly(3,4-ethylenedioxythiophene), polystyrene sulfonic acid, poly(3-hexylthiophene), triphenylamine with triptycene as a core, 3,4-ethylenedioxythiophene-methoxytriphenylamine, N-(4-aniline)carbazole-spirobifluorene, polythiophene, phosphoryl single molecule, carbazolyl single molecule, sulfo single molecule, triphenylamine single molecule, aryl single molecule, metal oxide, and cuprous thiocyanate, and the metal element in the metal oxide includes at least one of Ni, Mo, and Cu.

In one embodiment, the present application further provides a solar cell. The solar cell comprises the above light conversion layer.

The light conversion layer uses all the technical solutions of the above embodiments, and therefore, it has at least all the beneficial effects brought about by the technical solutions of the above embodiments, which will not be repeated here.

In the case of using a solar cell comprising the above light conversion layer, by introducing the up-conversion luminescent material and/or down-conversion luminescent material into the light conversion layer, long-wavelength band (low energy) and/or short-wavelength band (high energy) photons can be absorbed and converted into wavebands that can be absorbed by the light absorption layer, which is beneficial to improving the solar spectrum utilization rate and the output performance of the solar cell.

In one embodiment, in a first direction, the solar cell comprises sequentially an upper electrode, a first charge transport layer, a light absorption layer, a second charge transport layer, and a lower electrode; the first charge transport layer comprises the light conversion layer as described above, the charge transport material in the first charge transport layer includes one of an electron transport material and a hole transport material; the charge transport material in the second charge transport layer includes the other one of the electron transport material and the hole transport material.

Electrode: The main function of the electrode is to collect electrons/holes from the charge transport layer.

Light absorption layer: The light absorption layer comprises a light absorption material and a material with a photoelectric conversion function. The light absorption material absorbs photons of sunlight to generate excitation and excite electrons in a valence band to generate photoinduced hole and electron pairs.

FIG. 1 shows a schematic structural view of a solar cell according to one embodiment. The solar cell comprises, sequentially from top to bottom, an upper electrode 1, a first charge transport layer 2, a light absorption layer 3, a second charge transport layer 4, and a lower electrode 5. By introducing the up-conversion luminescent material and/or down-conversion luminescent material into the first charge transport layer, long-wavelength band (low energy) and/or short-wavelength band (high energy) photons can be absorbed and converted into wavebands that can be absorbed by the light absorption layer, which is beneficial to improving the solar spectrum utilization rate and the output performance of the solar cell.

In one embodiment, the materials of the upper electrode and/or the lower electrode include an organic conductive material and/or an inorganic conductive material.

In one embodiment, the organic conductive material includes at least one of poly(3,4-ethylenedioxythiophene), polythiophene, and polyacetylene; and/or the inorganic conductive material includes at least one of fluorine-doped SnO₂ transparent conductive glass, aluminum-doped zinc oxide transparent conductive glass, and a metal.

In the present application, the specific types of the materials of the upper electrode and the lower electrode are not limited, as long as it can achieve the conductive function. It can be an organic conductive material, e.g., a conductive polymer (poly(3,4-ethylenedioxythiophene), polythiophene, polyacetylene, etc.); or may be an inorganic conductive material, e.g., a transparent conductive oxide (FTO, ITO, AZO, etc.), a metal, or a carbon derivative.

FTO conductive glass is fluorine-doped SnO₂ transparent conductive glass (SnO₂:F), abbreviated as FTO. ITO conductive glass is made by plating a layer of indium tin oxide (commonly known as ITO) film on the basis of sodium-and-calcium-based or silicon-and-boron-based substrate plate glass by means of magnetron sputtering. AZO is the abbreviation of aluminum-doped zinc oxide(ZnO) transparent conductive glass.

In one embodiment, the material of the light absorption layer includes perovskite, and the structural formula of the perovskite is ABX₃, where A is an inorganic cation and/or an organic cation, B is an inorganic cation and/or an organic cation, and X is an inorganic anion and/or an organic anion.

In the present application, the material of the light absorption layer is not limited. Preferably, the material of the light absorption layer includes perovskite, and the structural formula of the perovskite is ABX₃, where A is an inorganic cation and/or an organic cation, B is an inorganic cation and/or an organic cation, and X is an inorganic anion and/or an organic anion.

For example, A is an inorganic cation, or an organic cation, or a mixture of an inorganic cation and an organic cation. B is an inorganic cation, or an organic cation, or a mixture of an inorganic cation and an organic cation. X is an inorganic anion, or an organic anion, or a mixture of an inorganic anion and an organic anion.

Perovskite materials are usually a large class of materials with an ABX₃ structure as the main structure. For example, the A position is Cs⁺, CH₃NH₂⁺, and CH₂(NH₂)⁺, the B position is Pb²⁺ or Sn²⁺, and X is a halogen ion of Cl⁻, Br⁻, I⁻, etc. It is a cubic close-packed structure formed by the halide octahedron BX₆ and the cation in the A position under the action of hydrogen bonding. An organic-inorganic hybrid lead halide perovskite with this structure has the advantages of a low cost, a high visible light internal absorption coefficient, a high carrier mobility, an adjustable band gap, easy synthesis by a solution method, etc.

It can be understood that the optical band gap of the perovskite material with determined composition is fixed, so that the solar spectrum utilization cannot be maximized, and long-wavelength band will directly penetrate the light absorption layer. By introducing the up-conversion luminescent material and/or the down-conversion luminescent material, short-wavelength band and/or long-wavelength band photons can be absorbed and converted into a visible waveband that can be effectively absorbed by perovskite, thereby improving the solar spectrum utilization rate and the current level of a device; in addition, by directly integrating the up-conversion luminescent material and/or the down-conversion luminescent material into the first charge transport layer, the process complexity can be reduced, the number of interfaces can be reduced, and the intrinsic structural advantages of the device can be ensured.

In one embodiment, preparation methods for the upper electrode, first charge transport layer, light absorption layer, second charge transport layer, and lower electrode include chemical bath deposition method, electrochemical deposition method, chemical vapor deposition method, physical epitaxial growth method, thermal evaporation co-evaporation method, atomic layer deposition method, magnetron sputtering method, precursor solution spin coating method, precursor solution slit coating method, precursor solution blade coating method, and mechanical lamination method.

During the process of preparing solar cells, the preparation method for each layer is not limited, for example, the preparation method can be chemical bath deposition method, electrochemical deposition method, chemical vapor deposition method, physical epitaxial growth method, thermal evaporation co-evaporation method, atomic layer deposition method, magnetron sputtering method, precursor solution spin coating method, precursor solution slit coating method, precursor solution blade coating method, and mechanical lamination method.

Chemical bath deposition method: Chemical bath deposition is a technique in which a chemical reaction occurs in a liquid phase, followed by deposition on a substrate.

Electrochemical deposition method: Electrochemical deposition refers to a technique of forming a plating layer by the migration of positive and negative ions as a current passes through an electrolyte solution under the action of an external electric field and the redox reaction of gain and loss electrons on the electrodes.

Chemical vapor deposition method is a process in which a gaseous or vaporous substance is used to react on the vapor phase or gas-solid interface to generate a solid deposit.

Physical epitaxial growth method: Epitaxial growth refers to growing, on a single crystal substrate (substrate plate), a single crystal layer, which meets certain requirements and has the same crystal orientation as the substrate, just like the original crystal has been extended outwards for a distance.

The atomic layer deposition method is a thin film formation technique in which a continuous chemical reaction is used in a vapor phase.

The magnetron sputtering method means that argon ions are accelerated by a cathode to bombard a surface of a cathode target, and atoms on the target surface are sputtered out and deposited on the substrate surface to form a thin film.

The precursor solution spin coating method is an abbreviation of spin coating method. The equipment therefor mainly includes a spin coater. The spin coating method comprises three steps: batching, high-speed rotation, and evaporation to form a film. The thickness of the formed film is controlled by controlling the spin coating time, the rotation speed, the dripping amount, and the concentration and viscosity of the solution used.

The precursor solution slit coating method is a coating technique in which under a certain pressure, a coating solution is pressed out along a gap of a mold and transferred to a moving substrate.

The precursor solution scrape method is a coating method in which a scraper is used for coating to prepare a thick coating film.

For example, a preparation method for a charge transport layer involves dissolving a charge transport material and a conversion material in a solvent to obtain a charge transport layer slurry; applying the charge transport layer slurry to an upper electrode by a spin coating method; and drying the charge transport layer slurry to obtain a charge transport layer having a preset thickness.

In one embodiment, the present application further provides an electrical apparatus. The electrical apparatus comprises the solar cell as described above.

The solar cell uses all the technical solutions of the above embodiments, and therefore, it has at least all the beneficial effects brought about by the technical solutions of the above embodiments, which will not be repeated here.

### Embodiments

### Embodiment 1

1) The surface of FTO conductive glass with specifications of 2.0 cm × 2.0 cm was successively washed twice with acetone and isopropanol. The FTO conductive glass was immersed in deionized water for ultrasonic treatment for 10 min, then dried in an air blast drying dry oven, and placed in a glove box (N₂ atmosphere). It was used as an upper electrode.
2) Preparation of down-conversion-charge (electron) transport layer: A mixed aqueous solution of 1 wt.% tetraethyl rhodamine and 3 wt.% SnO₂ nano-colloid was spin-coated on an FTO layer at 4000 rpm to 6500 rpm, and then heated at 150°C for 15 min on a constant-temperature hot table. The thickness thereof was 40 nm.
3) Preparation of perovskite layer (light absorption layer): A solution of FAPbI₃ in DMF with a concentration of 1.5 mol/L was spin-coated on the resulting electron transport layer at a speed of 3000 rpm to 4500 rpm, and the electron transport layer was then transferred to a constant-temperature hot table, heated at 100°C for 30 min, and cooled to room temperature to form a perovskite layer with a thickness of 500 nm.
4) Preparation of second charge transport layer: A solution of Spiro-OMeTAD in chlorobenzene with a concentration of 73 mg/mL was spin-coated on the perovskite layer at a speed of 3000 rpm to 4000 rpm. The thickness thereof was 150 nm.
5) Preparation of Ag electrode (lower electrode): The above sample was put into a vacuum coating machine, and an Ag electrode was evaporated on the surface of the resulting hole transport layer under 5 × 10⁻⁴ Pa vacuum condition at an evaporation rate of 0.1 angstroms/s. The thickness of the Ag electrode was 80 nm.

Thus, the perovskite solar cell of Embodiment 1 was obtained.

Embodiments 2 to 11: On the basis of Embodiment 1, the parameters, i.e., the type and proportion of the down-conversion luminescent material, the up-conversion luminescent material, and the thickness of the charge transport layer, were adjusted to obtain Embodiments 2 to 11.

Comparative Embodiment 1: The preparation of the upper electrode, the perovskite layer, the second charge transport layer, and the lower electrode were the same as in Embodiment 1.

Preparation of first charge (electron) transport layer: A mixed aqueous solution of 3 wt.% SnO₂ nano-colloid was spin-coated on an FTO layer at 4000 rpm to 6500 rpm, and then heated at 150°C for 15 min on a constant-temperature hot table. The thickness thereof was 40 nm.

Thus, the perovskite solar cell of Comparative Embodiment 1 was obtained.

### Performance test of perovskite solar cell

The perovskite photovoltaic cells of the embodiments and comparative embodiments were subjected to performance tests.

Specifically, the energy conversion efficiency of the perovskite cell of each of the embodiments and comparative embodiments was measured. In the atmospheric environment, a volt-ampere characteristic curve of the cell under light source irradiation was measured by a four-channel digital source meter (Keithley 2440) using an AM1.5G standard light source as a simulated solar light source to obtain the open-circuit voltage Voc, short-circuit current density Jsc, and fill factor FF (Fill Factor) of the cell, and thus, the energy conversion efficiency Eff (Efficiency) of the cell was calculated. It can be understood that the introduction of the up-conversion luminescent material and/or down-conversion luminescent material into the solar cell is beneficial to improving the solar spectrum utilization rate, increasing the photoinduced current, and further improving the energy conversion efficiency.

The energy conversion efficiency was calculated as follows: Eff = Pout/Popt = Voc×Jsc×(Vmpp×Jmpp)/(Voc×Jsc)
= Voc×Jsc×FF
where Pout, Popt, Vmpp, and Jmpp were the working output power of the cell, the power of the incident light, the maximum power point voltage of the cell, and the maximum power point current of the cell, respectively.

The results are recorded in Table 1.

**Table 1 Table of experimental data**

| / | First charge transport layer | | | | | | | Energy conversion efficiency Eff (%) |
|---|---|---|---|---|---|---|---|---|
| | Down-conversion luminescent material | | Up-conversion luminescent material | | Electron transport material | | Thickness | |
| | Material | Mass proportion % | Material | Mass proportion % | Material | Mass proportion % | | |
| Comparative Embodiment 1 | / | | / | / | SnO₂ | 100 | 40 | 19.5 |
| Embodiment 1 | Tetraethyl rhodamine | 25 | / | / | SnO₂ | 75 | 40 | 20.8 |
| Embodiment 2 | Tetraethyl rhodamine | 1 | / | / | SnO₂ | 99 | 40 | 19.6 |
| Embodiment 3 | Tetraethyl rhodamine | 50 | / | / | SnO₂ | 50 | 40 | 20.0 |
| Embodiment 4 | Tetraethyl rhodamine | 75 | / | / | SnO₂ | 25 | 40 | 19.6 |
| Embodiment 5 | Tetraethyl rhodamine | 25 | / | / | SnO₂ | 75 | 20 | 20.4 |
| Embodiment 6 | Tetraethyl rhodamine | 25 | / | / | SnO₂ | 75 | 30 | 20.6 |
| Embodiment 7 | Tetraethyl rhodamine | 25 | / | / | SnO₂ | 75 | 60 | 20.2 |
| Embodiment 8 | Rhodamine | 25 | / | / | SnO₂ | 75 | 40 | 20.4 |
| Embodiment 9 | Phycoeryth rin | 25 | / | / | SnO₂ | 75 | 40 | 20.3 |
| Embodiment 10 | / | / | NaYF₄ | 25 | SnO₂ | 75 | 40 | 20.7 |
| Embodiment 11 | Tetraethyl rhodamine | 25 | NaYF₄ | 25 | SnO₂ | 50 | 40 | 21.4 |

### Embodiment 12

1) The surface of FTO conductive glass with specifications of 2.0 cm × 2.0 cm was successively washed twice with acetone and isopropanol. The FTO conductive glass was immersed in deionized water for ultrasonic treatment for 10 min, then dried in an air blast drying dry oven, and placed in a glove box (N₂ atmosphere). It was used as an upper electrode.
2) Light conversion layer: A mixed aqueous solution of 1 wt.% tetraethyl rhodamine and 1 wt.% NaYF₄ was spin-coated on an FTO layer at 4000 rpm to 6500 rpm, and then heated at 150°C for 15 min on a constant-temperature hot table. The thickness thereof was 40 nm.
3) Preparation of charge (electron) transport layer: A mixed aqueous solution of 3 wt.% SnO₂ nano-colloid was spin-coated on an FTO layer at 4000 rpm to 6500 rpm, and then heated at 150°C for 15 min on a constant-temperature hot table. The thickness thereof was 40 nm.
4) Preparation of perovskite layer (light absorption layer): A solution of FAPbI₃ in DMF with a concentration of 1.5 mol/L was spin-coated on the resulting electron transport layer at a speed of 3000 rpm to 4500 rpm, and the electron transport layer was then transferred to a constant-temperature hot table, heated at 100°C for 30 min, and cooled to room temperature to form a perovskite layer with a thickness of 500 nm.
5) Preparation of second charge transport layer: A solution of Spiro-OMeTAD in chlorobenzene with a concentration of 73 mg/mL was spin-coated on the perovskite layer at a speed of 3000 rpm to 4000 rpm. The thickness thereof was 150 nm.
6) Preparation of Ag electrode (lower electrode): The above sample was put into a vacuum coating machine, and an Ag electrode was evaporated on the surface of the resulting hole transport layer under 5 × 10⁻⁴ Pa vacuum condition at an evaporation rate of 0.1 angstroms/s. The thickness of the Ag electrode was 80 nm.

Thus, the perovskite solar cell of Embodiment 12 was obtained.

Embodiment 13: On the basis of Embodiment 12, the light conversion layer was arranged between the upper electrode and the first charge transport layer.

Embodiment 14: On the basis of Embodiment 12, the light conversion layer was arranged between the first charge transport layer and the light absorption layer.

**Table 2 Table of experimental data**

| / | Light conversion layer | | | | | | Energy conversion efficiency Eff (%) |
|---|---|---|---|---|---|---|---|
| | Material | Mass proportion % | Material | Mass proportion % | Thickness | Arrangement position | |
| Embodiment 12 | Tetraethyl rhodamine | 50 | NaYF₄ | 50 | 40 | The light conversion layer was arranged on a surface of the upper electrode | 19.6 |
| Embodiment 13 | Tetraethyl rhodamine | 50 | NaYF₄ | 50 | 40 | The light conversion layer was arranged between the upper electrode and the first charge transport layer | 19.7 |
| Embodiment 14 | Tetraethyl rhodamine | 50 | NaYF₄ | 50 | 40 | The light conversion layer was arranged between the first charge transport | 19.8 |

| | | | | | | | |
|---|---|---|---|---|---|---|---|
| | | | | | | layer and the light absorption layer | |

Embodiment 15: On the basis of Embodiment 12, step 2) was not carried out, and an up-conversion luminescent material and a down-conversion luminescent material were added to the upper electrode.

**Table 3 Table of experimental data**

| / | Upper electrode | | | | | | | Energy conversion efficiency Eff (%) |
|---|---|---|---|---|---|---|---|---|
| | Down-conversion luminescent material | | Up-conversion luminescent material | | Upper electrode material | | Thickness | |
| | Material | Mass proportion % | Material | Mass proportion % | Material | Mass proportion % | | |
| Embodiment 15 | Tetraethyl rhodamine | 25 | NaYF₄ | 25 | 50 | 50 | 40 | 19.8 |

As can be seen from Table 1 to Table 3, after the introduction of the up-conversion luminescent material and/or the down-conversion luminescent material into the solar cell, the energy conversion efficiency of the solar cells was improved.

The foregoing descriptions are merely some preferred embodiments of the present application, but are not intended to limit the patent scope of the present application. Any equivalent structural transformations or equivalent process transformations made under the application concept of the present application by using the content of the specification and the accompanying drawings, or direct/indirect application of the content of the specification and accompanying drawings to other related technical fields all fall within the patent scope of protection of the present application.

## Claims

1. A light conversion layer, wherein the light conversion layer is applied to a solar cell, the light conversion layer comprises a conversion material, the conversion material comprises an up-conversion luminescent material and/or a down-conversion luminescent material, and the light conversion layer is arranged on a light incident side of a light absorption layer of the solar cell.

2. The light conversion layer according to claim 1, wherein the solar cell comprises an upper electrode, and the light conversion layer is arranged on a surface of the upper electrode;
and/or the solar cell comprises an upper electrode and a first charge transport layer, and the light conversion layer is arranged between the upper electrode and the first charge transport layer;
and/or the solar cell comprises a first charge transport layer and a light absorption layer, and the light conversion layer is arranged between the first charge transport layer and the light absorption layer.

3. The light conversion layer according to claim 1, wherein the solar cell comprises an upper electrode, the light conversion layer is the upper electrode, and the light conversion layer comprises an upper electrode material and the conversion material.

4. The light conversion layer according to claim 1, wherein the solar cell comprises a first charge transport layer, the light conversion layer is the first charge transport layer, and the light conversion layer comprises a charge transport material and the conversion material.

5. The light conversion layer according to claim 4, wherein the proportion of the mass of the conversion material in the total mass of the materials of the light conversion layer is in a range of 1% to 75%.

6. The light conversion layer according to claim 5, wherein the proportion of the mass of the conversion material in the total mass of the materials of the light conversion layer is in a range of 25% to 60%.

7. The light conversion layer according to any one of claims 1 to 6, wherein the thickness of the light conversion layer is in a range of 30 nm to 60 nm.

8. The light conversion layer according to claim 7, wherein the thickness of the light conversion layer is in a range of 40 nm to 50 nm.

9. The light conversion layer according to any one of claims 4 to 6, wherein the light conversion layer comprises the charge transport material, the up-conversion luminescent material, and the down-conversion luminescent material, and the proportion of the mass of the up-conversion luminescent material in the total mass of the materials of the light conversion layer is greater than 0 and less than or equal to 25%;
the proportion of the mass of the down-conversion luminescent material in the total mass of the materials of the light conversion layer is greater than 0 and less than or equal to 25%; and
the proportion of the mass of the charge transport material in the total mass of the materials of the light conversion layer is greater than or equal to 50% and less than 100%.

10. The light conversion layer according to any one of claims 1 to 6 and 8, wherein the conversion material comprises an up-conversion luminescent material, and the up-conversion luminescent material comprises at least one of an organic compound or an inorganic compound.

11. The light conversion layer according to claim 10, wherein the organic compound comprises at least one of 4CzIPN, thioxanthone, and triphenylamine;
and/or the inorganic compound comprises at least one of NaYF₄, NaLuF₄, NaGdF₄, NaYbF₄, NaYGd, NaYLu, NaYNd, NaGd(WO₄)₂, LiErF, BaYF₅, BaLuF₅, BaGdF₅, BaYb₂F, CaS, LiLa(MoO₄)₂, Gd₂O₃, ZrYO, YAlO₃, CaWO₄, and the NaYF₄, NaLuF₄, NaGdF₄, NaYbF₄, NaYGd, NaYLu, NaYNd, NaGd(WO₄)₂, LiErF, BaYF₅, BaLuF₅, BaGdF₅, BaYb₂F, CaS, LiLa(MoO₄)₂, Gd₂O₃, ZrYO, YAlO₃, and CaWO₄ doped with one or more of the rare earth elements Yb, Er, Tm, Eu, Sm, Bi, and Ho.

12. The light conversion layer according to any one of claims 1 to 6, 8, and 11, wherein the conversion material comprises a down-conversion luminescent material, and the down-conversion luminescent material comprises a fluorescent material and/or a phosphorescent material.

13. The light conversion layer according to claim 12, wherein the down-conversion luminescent material comprises a fluorescent material, and the fluorescent material comprises at least one of riboflavin, a fluorescein compound, a rhodamine compound, phycoerythrin, an iridium complex, a rare earth element complex, a polyfluorene compound, a coumarin compound, a naphthalimide compound, a polyacene compound, a fluorine-and-boron-based dipyrrole compound, a Resorufin compound, a pyrazoline compound, a triphenylamine compound, a carbazole compound, a green fluorescent protein, a diamine fluorescent compound, a perovskite luminescent nanomaterial, and a thermally activated delayed fluorescent compound;
and/or the down-conversion luminescent material comprises a phosphorescent material, the phosphorescent material comprises a matrix, and the matrix comprises at least one of sulfide, oxide, selenide, fluoride, phosphate, silicate, and tungstate of a metal of group II;
and/or the down-conversion luminescent material comprises a phosphorescent material, the phosphorescent material comprises a matrix and an activator, and the activator comprises a heavy metal.

14. The light conversion layer according to any one of claims 4 to 6, wherein the charge transport material comprises an electron transport material or a hole transport material.

15. The light conversion layer according to claim 14, wherein the electron transport material comprises at least one of an imide compound, a quinone compound, fullerene and a derivative thereof, a metal oxide, a semiconductor material oxide, a titanate, and a fluoride.

16. The light conversion layer according to claim 15, wherein the imide compound comprises at least one of phthalimide, succinimide, N-bromosuccinimide, glutarimide, or maleimide;
and/or the quinone compound comprises at least one of benzoquinone, naphthoquinone, phenanthrenequinone, or anthraquinone;
and/or the fullerene and the derivative thereof comprise at least one of C₆₀ and PCBM;
and/or the metal element in the metal oxide comprise at least one of Mg, Cd, Zn, In, Pb, W, Sb, Bi, Hg, Ti, Ag, Mn, Fe, V, Sn, Zr, Sr, Ga, and Cr;
and/or the semiconductor material oxide comprise silicon oxide;
and/or the titanate comprises at least one of strontium titanate and calcium titanate;
and/or the fluoride comprises at least one of lithium fluoride and calcium fluoride.

17. The light conversion layer according to claim 14, wherein the hole transport material comprises at least one of 2,2',7,7'-tetrakis(N,N-p-methoxyaniline)-9,9'-spirobifluorene, methoxytriphenylamine-fluoroformamidine, poly[bis(4-phenyl)(2,4,6-trimethylphenyl)amine], poly(3,4-ethylenedioxythiophene), polystyrene sulfonic acid, poly(3-hexylthiophene), triphenylamine with triptycene as a core, 3,4-ethylenedioxythiophene-methoxytriphenylamine, N-(4-aniline)carbazole-spirobifluorene, polythiophene, phosphoryl single molecule, carbazolyl single molecule, sulfo single molecule, triphenylamine single molecule, aryl single molecule, metal oxide, and cuprous thiocyanate, and the metal element in the metal oxide comprises at least one of Ni, Mo, and Cu.

18. A solar cell, wherein the solar cell comprises the light conversion layer according to any one of claims 1 to 17.

19. The solar cell according to claim 18, wherein in a first direction, the solar cell comprises sequentially an upper electrode, a first charge transport layer, a light absorption layer, a second charge transport layer, and a lower electrode;
the first charge transport layer comprises the light conversion layer according to any one of claims 1 to 17, and the charge transport material in the first charge transport layer comprises one of an electron transport material and a hole transport material; and
the charge transport material in the second charge transport layer comprises the other one of the electron transport material and the hole transport material.

20. The solar cell according to claim 19, wherein the materials of the upper electrode and/or the lower electrode comprise an organic conductive material and/or an inorganic conductive material.

21. The solar cell according to claim 20, wherein the organic conductive material comprises at least one of poly(3,4-ethylenedioxythiophene), polythiophene, and polyacetylene;
and/or the inorganic conductive material comprises at least one of fluorine-doped SnO₂ transparent conductive glass, aluminum-doped zinc oxide transparent conductive glass, and a metal.

22. The solar cell according to claim 19 or 21, wherein the material of the light absorption layer comprises perovskite, and the structural formula of the perovskite is ABX₃, where A is an inorganic cation and/or an organic cation, B is an inorganic cation and/or an organic cation, and X is an inorganic anion and/or an organic anion.

23. An electrical apparatus comprising the solar cell according to any one of claims 18 to 22.
